# FASCICULE DE BREVET EUROPEEN

(11) **EP 2 227 927 B1**
(45) Date de publication et mention de la délivrance du brevet: **31.08.2016**
(21) Numéro de dépôt: 08859312.4
(22) Date de dépôt: 09.12.2008
(51) Int. Cl.: H05K 1/14, H05K 3/10, H05K 3/28, H05K 3/42, H05K 3/46

(54) **PIÈCES EN MATÉRIAU COMPOSITE ÉLECTRO-STRUCTURAL**
AUS ELEKTROSTRUKTURELLEM VERBUNDMATERIAL HERGESTELLTE TEILE
PARTS MADE OF ELECTROSTRUCTURAL COMPOSITE MATERIAL

(30) Priorité: 10.12.2007 FR 0759671
(43) Date de publication de la demande: 15.09.2010
(73) Titulaire: Airbus Group SAS, 31700 Blagnac (FR)
(72) Inventeur: ASPAS-PUERTOLAS, Jesus, F-75015 Paris (FR)
(74) Mandataire: Ipside
(86) Numéro de dépôt international: PCT/EP2008/067090
(87) Numéro de publication internationale: WO 2009/074564

(56) Documents cités:
- WO-A-01/80374
- WO-A-2005/123375
- FR-A1- 2 879 998
- GB-A- 1 258 702
- US-B2- 7 047 349

## Description

La présente invention concerne une structure assemblée de pièces en matériau composite. Plus particulièrement la présente invention concerne une structure assemblée de pièces en matériau composite, qui est adaptée à la réalisation de structures aéronautiques travaillantes et au déploiement d'un réseau électrique dans un aéronef.

L'utilisation de matériaux composites est de nos jours largement répandue dans de nombreux domaines industriels, notamment dans les domaines de l'aéronautique et de l'aérospatiale, qui bénéficient des caractéristiques variées que possèdent ces matériaux.

Les matériaux composites sont par exemple utilisés dans la fabrication de structures travaillantes d'aéronefs, dans lesquels des propriétés combinées de légèreté et de résistance mécanique permettent de fabriquer des structures travaillantes plus légères qu'en utilisant des matériaux conventionnels, mais de résistance mécanique équivalente, et donc de fabriquer un aéronef qui consomme moins d'énergie ou qui transporte une charge utile plus importante.

La fabrication des structures travaillantes nécessite une étape de dimensionnement structural dans laquelle les contraintes auxquelles les différentes structures seront soumises (mécaniques, thermiques, etc.) sont identifiées, et les caractéristiques des matériaux composites les composant sont déterminées.

Après la fabrication des structures travaillantes, les différents systèmes que comporte l'aéronef sont installés. Un aéronef comporte en général plusieurs types de systèmes comme par exemple les systèmes électriques/électroniques, tels que l'avionique, le réseau de distribution de puissance, ou encore le réseau de transmission de données passagers comme les signaux audio/vidéo du système de divertissement.

L'installation des systèmes électriques/électroniques qui sont de plus en plus nombreux et complexes, nécessite de déployer une pluralité de faisceaux de câbles qui sont placés par exemple le long des structures travaillantes où lesdits faisceaux de câbles sont exposés à d'éventuels endommagements.

Il est connu du brevet US 7047349 d'intégrer tout le réseau électrique/électronique directement dans une pièce unique réalisée en matériau composite, entre des plis dudit matériau composite, dans le cas d'un avion comportant essentiellement une pièce supérieure et une pièce inférieure.

Dans le brevet US 7047349, l'intégration d'éléments électriques/électroniques variés (câbles, boîtiers d'interconnexion, etc.) entre des plis d'un matériau composite a un impact sur l'homogénéité dudit matériau, qui a pour effet de réduire sa résistance mécanique.

De plus l'intégration de tout le réseau électrique dans une seule pièce n'est pas adaptée à la réalisation d'avions de ligne de taille importante, dont des parties sont en général réalisées à partir de nombreuses pièces en matériau composite qui sont assemblées.

L'intégration des éléments électriques/électroniques dans les structures travaillantes pose en outre un problème de compatibilité électromagnétique comme par exemple la protection contre la foudre desdits éléments, qui est un problème particulièrement important pour les aéronefs comportant des structures réalisées à partir de matériaux composites.

La présente invention concerne des pièces structurales rigides de structure travaillante d'aéronef en matériau composite stratifié qui intègrent au moins une couche conductrice de réseau, comportant un réseau de câbles électriquement conducteurs qui ont un rôle structural dans ladite pièce. De préférence, les pièces intègrent également une couche métallique pour assurer une référence électrique pour l'installation des systèmes électriques/électroniques. La couche métallique assure en outre une protection électromagnétique du réseau de câbles électriquement conducteurs. Les pièces sont assemblées pour réaliser une structure travaillante, et chaque pièce comporte des moyens permettant de raccorder des câbles conducteurs de différentes pièces pour former à l'échelle de la structure assemblée un réseau électrique.

Une pièce structurale rigide de structure travaillante d'aéronef en matériau composite stratifié selon la présente invention incorpore des câbles électriquement conducteurs. La pièce structurale est caractérisée en ce qu'elle comporte :
- au moins trois couches structurales comportant des fibres maintenues par une matrice réalisée à partir d'une résine thermodurcissable ou thermoplastique,
- au moins une couche conductrice de réseau située entre deux desdites au moins trois couches structurales, comportant un réseau de câbles électriquement conducteurs, les câbles électriquement conducteurs étant agencés dans toute la pièce structurale de manière sensiblement régulière et étant isolés électriquement des deux couches structurales par un matériau diélectrique,
   au moins une couche conductrice de référence située entre deux desdites au moins trois couches structurales, ladite au moins une couche conductrice de référence étant électriquement conductrice dans toutes les directions,
- des moyens de connexion électrique de raccordement électrique de pièces structurales entre elles, auxquels sont raccordés électriquement des câbles électriquement conducteurs de l'au moins une couche de réseau et l'au moins une couche conductrice de référence.

En agençant régulièrement les câbles conducteurs dans toute la pièce structurale, les caractéristiques mécaniques de ladite pièce structurale sont sensiblement homogènes dans toute la pièce. Les câbles conducteurs sont en outre aptes à transmettre des signaux électriques d'un moyen de connexion électrique à un autre.

Dans un mode préféré de réalisation, la pièce structurale comporte au moins trois couches structurales et au moins une couche conductrice de référence située entre deux des au moins trois couches structurales. L'au moins une couche conductrice de référence est conductrice dans toutes les directions et est raccordée aux moyens de connexion électrique. L'au moins une couche conductrice de référence a un rôle structural et est apte à conduire une référence électrique.

Pour réaliser une pièce structurale particulièrement robuste, ladite pièce comporte au moins quatre couches structurales et au moins une couche d'un matériau de type alvéolaire, située entre deux couches structurales, pour obtenir une pièce dans un matériau de type sandwich.

La couche conductrice de référence est de préférence une feuille métallique, ou un grillage composé de câbles métalliques ou métallisés, ou une couche d'un matériau métallique alvéolaire.

Dans un mode particulier de réalisation, les moyens de connexion électrique sont des trous métallisés qui débouchent sur une face d'interconnexion de la pièce structurale.

Dans un autre mode de réalisation, les moyens de connexion électrique sont des connecteurs externes montés en surface sur une face d'interconnexion de ladite pièce structurale.

Les moyens de connexion électrique sont dans un autre mode de réalisation des connecteurs internes situés dans ladite pièce structurale et accessibles depuis une face d'interconnexion ou depuis un bord de ladite pièce structurale.

De préférence, le matériau diélectrique, isolant électriquement les câbles électriquement conducteurs des couches structurales, est de même composition que la résine thermodurcissable ou thermoplastique utilisée pour la réalisation des couches structurales.

Pour la réalisation de pièces structurales robustes, chaque couche structurale de la pièce comporte des fibres de carbone.

L'invention concerne également une structure travaillante d'aéronef assemblée qui comporte au moins deux pièces structurales rigides en matériau composite incorporant des câbles conducteurs électriquement.

La structure travaillante d'aéronef est caractérisée en ce que chaque pièce structurale comporte :
- au moins trois couches structurales comportant des fibres maintenues par une matrice réalisée à partir d'une résine thermodurcissable ou thermoplastique,
- au moins une couche conductrice de réseau située entre deux desdites au moins trois couches structurales, comportant un réseau de câbles électriquement conducteurs, les câbles électriquement conducteurs étant agencés dans toute la pièce structurale de manière sensiblement régulière et étant isolés électriquement des deux couches structurales par un matériau diélectrique,
   au moins une couche conductrice de référence située entre deux desdites au moins trois couches structurales, ladite au moins une couche conductrice de référence étant électriquement conductrice dans toutes les directions,
- des moyens de connexion électrique auxquels sont raccordés électriquement des câbles électriquement conducteurs de l'au moins une couche de réseau et l'au moins une couche conductrice de référence

La structure travaillante est également caractérisée en ce que les au moins deux pièces structurales sont raccordées électriquement par les moyens de connexion et forment un réseau électrique intégré dans la structure travaillante.

De préférence, chaque pièce structurale de la structure travaillante comporte au moins trois couches structurales et au moins une couche conductrice de référence située entre deux des au moins trois couches structurales, l'au moins une couche conductrice de référence étant conductrice dans toutes les directions et étant raccordée aux moyens de connexion électrique pour fournir une référence électrique.

Avantageusement, les moyens de connexion des pièces structurales sont raccordés électriquement par des moyens d'interconnexion externes qui sont par exemple amovibles.

Une telle structure travaillante assemblée est par exemple utilisée pour fabriquer un plancher en matériau composite de véhicule, notamment de type aéronef, ledit plancher intégrant un réseau électrique permettant de relier différents équipements.

La description suivante de modes de réalisation de l'invention est faite en se référant aux figures qui représentent de manière non limitative :
- Figure 1, une vue schématique éclatée d'une pièce structurale en matériau composite stratifié selon un premier mode de réalisation de l'invention,
- Figure 2, une vue schématique éclatée d'une pièce structurale en matériau composite stratifié selon un second mode de réalisation de l'invention,
- Figure 3a et figure 3b, des vues schématiques éclatées d'une pièce structurale en matériau composite stratifié selon un troisième mode de réalisation de l'invention et une variante de ce troisième mode,
- Figure 4a, figure 4b, figure 4c et figure 4d, des vues schématiques en perspective de plusieurs modes de réalisation de moyens de connexion électrique de la pièce structurale,
- Figure 5, une vue schématique d'une structure travaillante assemblée comportant une pluralité de pièces structurales.

La présente invention concerne des pièces structurales en matériau composite pour la fabrication de structures travaillantes de véhicules, en particulier de type aéronef, comme par exemple des panneaux pour la fabrication de planchers.

De telles pièces structurales sont en matériau composite de type comportant des fibres maintenues par une matrice qui est réalisée à partir d'une résine thermodurcissable, le plus souvent une résine époxy, ou à partir d'une résine thermoplastique, comme par exemple une résine à base de poly-éther-éther-cétone (PEEK), de poly-éther-cétone-cétone (PEKK), de polyétherimide (PEI), de polysulfure de phénylène (PPS), etc.

De telles pièces structurales sont des pièces rigides.

On comprend que lesdites pièces structurales, notamment lorsqu'elles sont réalisées en matériau composite à matrice thermoplastique, peuvent présenter une certaine plasticité lorsqu'elles sont portées à forte température, par exemple supérieure à 100°C. Toutefois lesdites pièces structurales sont rigides dans des conditions d'utilisation dites conditions normales, par exemple à température ambiante d'une cabine d'aéronef dans le cas de panneaux de plancher d'aéronef.

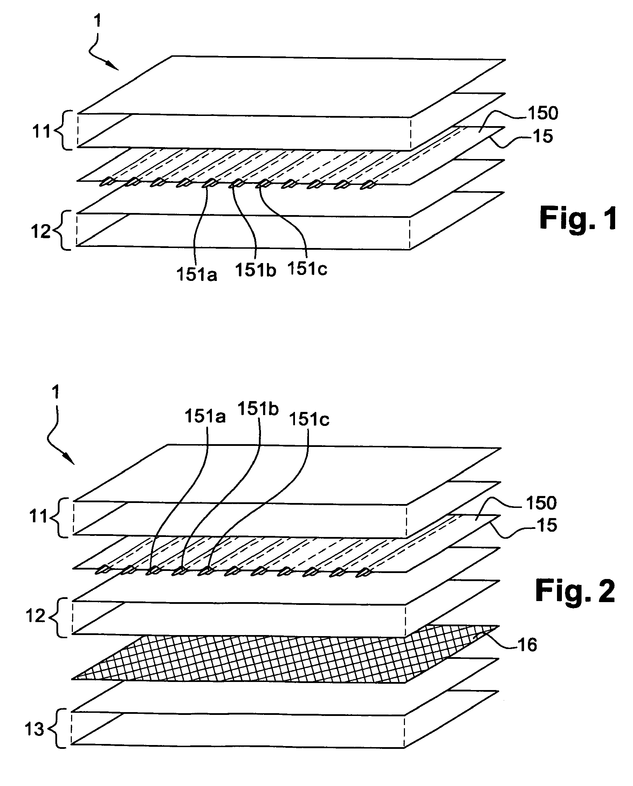

Tel que représenté sur la figure 1, une pièce en matériau composite stratifié comporte de manière conventionnelle une pluralité de couches assemblées entre elles.

La pièce structurale 1 en matériau composite stratifié selon l'invention comporte au moins une première couche structurale 11 et une seconde couche structurale 12. Les couches structurales 11 et 12 ont sensiblement les mêmes dimensions et ont des formes adaptées à la forme de ladite pièce structurale à réaliser, par exemple une forme simple telle que celle d'un panneau rectangulaire pour la fabrication de planchers d'aéronef.

Les couches structurales 11 et 12 sont de préférence de même nature, par exemple réalisées à partir de fibres de verre, de carbone ou d'aramide, lesdites fibres étant tissées ou unidirectionnelles, imprégnées d'une résine thermodurcissable ou thermoplastique formant une matrice. Lesdites couches structurales sont par exemple réalisées à partir de fibres pré-imprégnées ou de fibres sèches qui sont imprégnées de résine au cours du processus de fabrication de ladite pièce.

Une première couche conductrice électriquement, dite couche de réseau 15, est située entre les couches structurales 11 et 12, et a sensiblement la même forme et les mêmes dimensions que lesdites couches structurales.

La couche de réseau 15 est formée d'une couche de matériau diélectrique 150 assurant la liaison structurale avec les couches structurales 11 et 12. La couche de matériau diélectrique 150 est par exemple réalisée à partir d'une résine thermodurcissable ou thermoplastique, de préférence de même composition que la résine formant la matrice du matériau composite stratifié.

La couche de matériau diélectrique 150 incorpore un réseau de câbles conducteurs 151a - 151 c qui ne sont pas en contact entre eux et sont agencés de manière sensiblement régulière dans toute la pièce structurale 1. Par exemple lesdits câbles conducteurs sont sensiblement parallèles suivant un pas sensiblement régulier dans toute ladite pièce structurale, ou dans des zones de ladite pièce structurale telles que des zones qui ne sont pas traversées par des éléments de fixation. Les câbles conducteurs 151a - 151 c sont, dans un mode particulier de réalisation agencés par paires rapprochées.

Les câbles conducteurs 151a - 151c sont de préférence des câbles métalliques, par exemple en aluminium, cuivre, etc.

Les câbles conducteurs 151a - 151c ont de préférence le même diamètre. Dans un mode particulier de réalisation, lesdits câbles conducteurs ont des diamètres différents, par exemple deux diamètres d0 et d1, et sont agencés régulièrement dans la couche de matériau diélectrique 150, par exemple une alternance régulière de câbles conducteurs de diamètres d0 et d1.

Chaque câble conducteur 151a - 151 c comporte deux extrémités et est agencé de sorte que chaque extrémité dudit câble est située au voisinage d'un bord de la couche de réseau 15. Les extrémités d'un câble conducteur 151a - 151 c se trouvent de préférence au voisinage de bords différents, par exemple des bords opposés dans le cas d'une couche de réseau 15 de forme rectangulaire.

Les couches structurales 11 et 12 et la couche de réseau 15 sont assemblées, pour former la pièce structurale 1 en matériau composite, en utilisant un procédé conventionnel comme par exemple un procédé par transfert de résine ou encore un procédé autoclave. Notamment dans le cas d'une résine thermodurcissable, ledit procédé comporte une étape de cuisson au cours de laquelle ladite résine thermodurcissable est durcie.

La couche de réseau 15, du fait des câbles conducteurs 151a - 151 c et de la couche de matériau diélectrique 150 qui assure la liaison structurale avec les couches structurales 11 et 12, joue un rôle structural dans la pièce 1, et contribue à la résistance mécanique de ladite pièce.

Du fait de l'agencement sensiblement régulier des câbles conducteurs 151a - 151 c dans toute la couche de matériau diélectrique 150, les caractéristiques mécaniques de la pièce structurale 1 sont sensiblement homogènes en tout point de ladite pièce structurale.

La pièce structurale 1, du fait des câbles conducteurs 151a - 151 c situés à l'intérieur de la couche de matériau diélectrique 150, est apte à transmettre des signaux électriques d'une extrémité à l'autre de chaque câble conducteur, tels que des signaux de données ou de contrôle, et/ou à conduire des courants électriques dans le cas d'une alimentation en puissance. Dans le cas d'un agencement desdits câbles par paire, les signaux électriques sont par exemple des signaux différentiels.

Dans la suite de l'exposé, seul le cas de signaux électriques est décrit.

Les diamètres des câbles conducteurs 151a - 151c sont par exemple déterminés en fonction des caractéristiques des signaux électriques à transmettre, et un espacement entre lesdits câbles est de préférence tel que les interférences entre lesdits câbles sont minimisées.

Dans un mode particulier de réalisation, lesdits câbles conducteurs sont agencés à la manière d'un circuit imprimé, pour transmettre les signaux électriques dans des directions différentes, tout en étant répartis de manière sensiblement uniforme dans toute la pièce structurale 1. Si les caractéristiques mécaniques de la pièce structurale 1 sont dégradées localement, ladite pièce est par exemple renforcée localement en utilisant des inserts et/ou des raidisseurs pour assurer des caractéristiques mécaniques sensiblement homogènes en tout point.

Du fait de la couche de matériau diélectrique 150 isolante électriquement, les câbles conducteurs 151a - 151 c transmettant des signaux électriques sont électriquement isolés des couches structurales 11 et 12, ce qui est particulièrement avantageux dans le cas de couches structurales électriquement conductrices, par exemple des couches composées de fibres de carbone (« carbon fiber composite » ou CFC).

Dans un mode voisin de réalisation de la couche de réseau 15, non représenté, les câbles conducteurs 151a - 151c sont tissés sur une couche structurale, et chaque câble conducteur comporte une gaine en matériau diélectrique 150 qui isole électriquement ledit câble des couches structurales de la pièce structurale 1.

Dans un mode particulier de réalisation, non représenté, la pièce structurale 1 en matériau composite stratifié comporte au moins une seconde couche de réseau 15'. Dans le cas de couches de réseau 15 et 15' avec des câbles conducteurs sensiblement parallèles, lesdites couches de réseau ont de préférence des orientations différentes, par exemple de sorte que des câbles conducteurs de couches différentes sont sensiblement orthogonaux.

Du fait de la seconde couche de réseau 15', la résistance mécanique de la pièce structurale 1 est augmentée. Les caractéristiques mécaniques de ladite pièce structurale sont également plus homogènes du fait de l'orientation différente des deux couches de réseau 15 et 15'.

Avantageusement, des câbles conducteurs de couches conductrices différentes sont reliés électriquement. Par exemple, le câble conducteur 151a et un câble conducteur 151 a' de la couche de réseau 15' sont reliés au moyen d'une connexion traversante au niveau où lesdits câbles conducteurs, sensiblement orthogonaux, se croisent. En reliant des câbles conducteurs de couches de réseau différentes, un même signal électrique est transmis dans des directions différentes.

La figure 2 représente un second mode de réalisation de l'invention dans lequel la pièce structurale 1 comporte une couche électriquement conductrice, dite couche de référence 16, située entre la couche structurale 12 et une couche structurale 13.

La couche structurale 13 et la couche de référence 16 ont sensiblement la même forme et les mêmes dimensions que les couches structurales 11 et 12.

La couche de référence 16 est une couche essentiellement métallique, et est formée par exemple d'une feuille mince métallique, ou d'un tissu régulier de fibres métalliques ou métallisées, ou d'un grillage régulier de câbles métalliques ou métallisés.

La couche de référence 16, du fait de sa nature métallique et régulière, participe également de manière sensiblement homogène aux caractéristiques mécaniques de la pièce structurale 1.

La couche de référence 16 est en outre, également du fait de sa nature essentiellement métallique, conductrice dans toutes les directions. Par « conductrice dans toutes les directions », on entend qu'un signal électrique, appliqué en un point de la couche de référence 16, est transmis en tout point de ladite couche de référence. La couche de référence 16 est ainsi apte à conduire une référence électrique, par exemple une référence commune à tous les signaux électriques transmis par la couche de réseau 15, telle que la masse électrique.

La couche de référence 16 assure également une protection des câbles conducteurs 151a - 151c de la couche de réseau 15 contre des interférences électromagnétiques dont l'origine se trouve d'un côté d'une face de ladite couche de référence opposée à ladite couche de réseau. Des interférences électromagnétiques sont par exemple causées par des champs électromagnétiques forts émis par des radars, par des rayonnements des systèmes électriques/électroniques embarqués ou par la foudre.

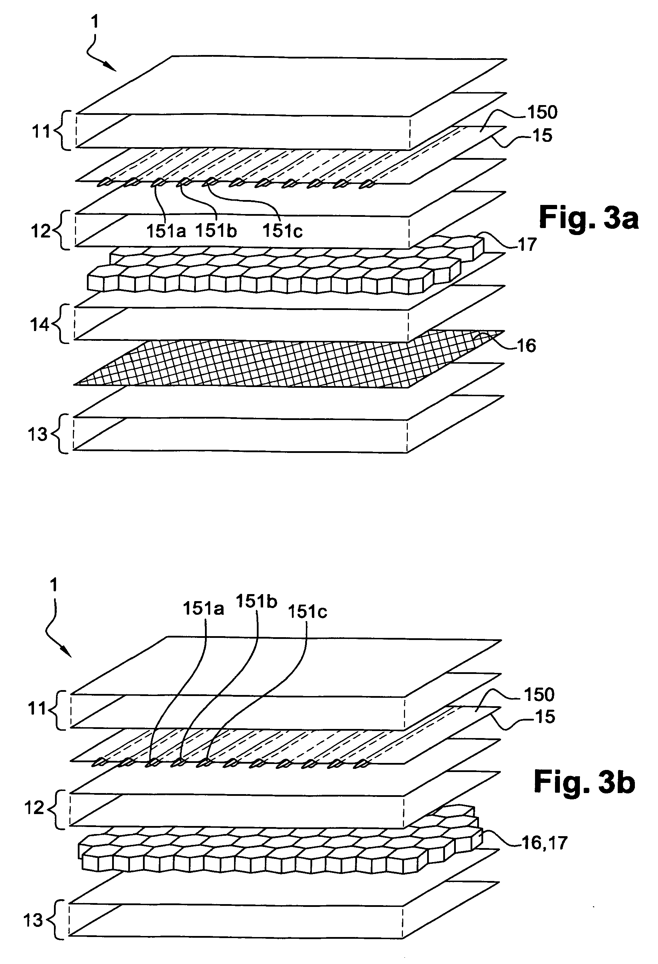

La figure 3a représente un troisième mode de réalisation d'une pièce structurale 1 selon l'invention, de type sandwich, dans lequel une couche d'un matériau alvéolaire 17, par exemple un matériau de type nid d'abeilles, est intercalée entre des couches, de préférence des couches structurales. Par exemple la couche alvéolaire 17 est située entre la couche structurale 12 et une couche structurale 14, et la couche de référence 16 est située entre les couches structurales 13 et 14.

Les matériaux de type sandwich sont particulièrement avantageux du fait d'un rapport résistance mécanique/poids élevé, et la couche alvéolaire 17 est par exemple réalisée en aluminium ou en Nomex®.

Dans un mode voisin de réalisation d'une pièce structurale 1 en matériau composite de type sandwich selon l'invention, représenté sur la figure 3b, la couche alvéolaire 17, réalisée dans un matériau conducteur électriquement, assure avantageusement les fonctions de la couche de référence 16.

Les couches structurales 11 - 14 sont dans un mode particulier de réalisation constituées d'une pluralité de couches, comme représenté sur les figures 1, 2, 3a et 3b. Le nombre de couches est essentiellement déterminé par les caractéristiques mécaniques et l'épaisseur voulues pour la pièce structurale 1.

Dans un autre mode de réalisation, non représenté, la pièce structurale 1, comporte deux couches de réseau 15 et 15' et la couche de référence 16, séparées par des couches structurales.

De manière plus générale, la pièce structurale 1 comporte une pluralité de couches de réseau et une pluralité de couches de référence. L'agencement desdites couches de réseau et de référence est par exemple tel qu'une couche de référence est intercalée entre deux couches de réseau pour réduire les interférences électromagnétiques de l'une vers l'autre et vice-versa, et/ou tel que les couches de réseau sont toutes situées entre deux couches de référence, pour améliorer la protection électromagnétique desdites couches de réseau contre des interférences générées par des champs électromagnétiques extérieurs ou par les rayonnements des systèmes électriques/électroniques embarqués.

La pièce structurale 1 en matériau composite stratifié comporte également des moyens de connexion électrique 18 qui sont raccordés électriquement à des câbles conducteurs de la couche de réseau 15 et à la couche de référence 16.

Des moyens de connexion électrique 18 sont raccordés aux deux extrémités des câbles conducteurs et au moins à deux points de la couche de référence 16. Les exemples décrits ci-après n'illustrent que les moyens de connexion électrique d'un côté de la pièce structurale 1, reliés à une extrémité de chaque câble conducteur raccordé, et des moyens de connexion électrique similaires sont utilisés pour la deuxième extrémité de chaque câble raccordé et pour le second point de ladite couche de référence.

Les moyens de connexion électrique 18 sont soit des connecteurs externes montés en surface de la pièce structurale 1 sur une face d'interconnexion, soit des connecteurs internes intégrés entre des couches formant ladite pièce structurale, pour un raccordement via la face d'interconnexion ou via le bord de ladite pièce structurale.

Les moyens de connexion de différentes pièces structurales sont connectés directement, c'est-à-dire qu'ils sont géométriquement adaptés pour assurer un contact électrique par l'assemblage mécanique des pièces, ou indirectement via des moyens d'interconnexion 5, qui raccordent des moyens de connexion de différentes pièces structurales, tels qu'un câble coaxial, une nappe informatique ou tout type de câble électrique apte à véhiculer un ou des signaux électriques.

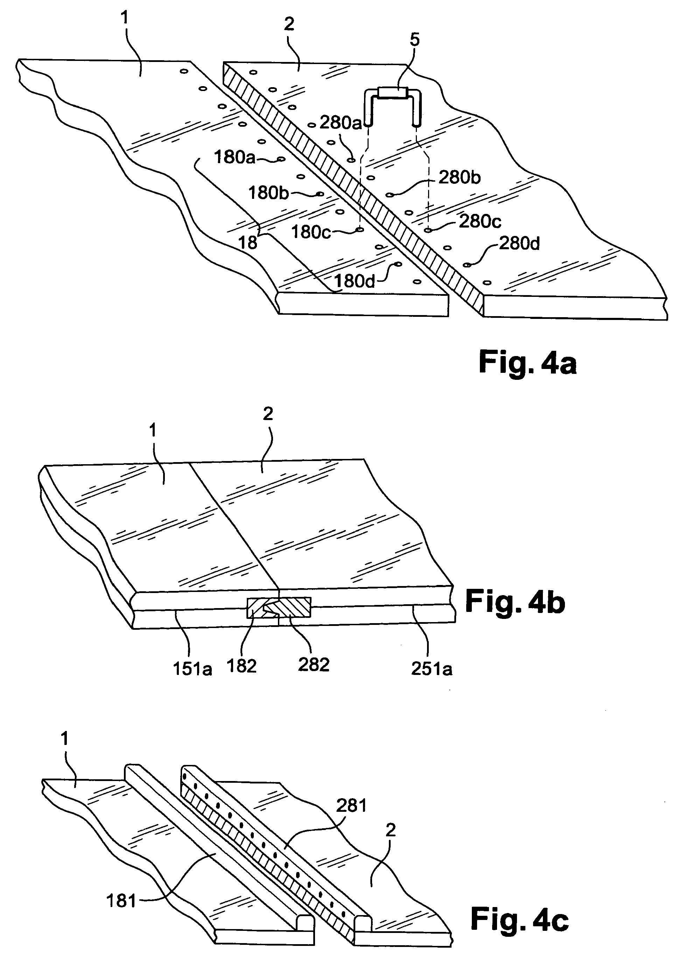

La figure 4a représente un premier mode de réalisation des moyens de connexion électrique 18, dans lequel lesdits moyens de connexion sont des connecteurs internes, en l'occurrence des trous métallisés 180a - 180d. Les trous 180a - 180d débouchent sur la face d'interconnexion au voisinage d'un bord de la pièce structurale 1, et chaque trou 180a - 180d relie électriquement un câble électrique respectivement 151a - 151 c de la couche de réseau 15 ou la couche conductrice de référence 16 à la face d'interconnexion.

Les trous 180a - 180d sont par exemple, mais pas nécessairement, alignés par rapport au bord de la pièce structurale 1. Dans le cas où les trous 180a - 180d traversent la pièce structurale 1, la couche de référence 16 comporte avantageusement des encoches au niveau des trous correspondant à des câbles conducteurs, de sorte qu'il n'y a pas de liaison électrique entre les câbles conducteurs 151a - 151 c et la couche de référence 16.

Par l'intermédiaire de ces trous 180a - 180d et de trous 280a - 280d réalisés dans une pièce structurale 2, les câbles conducteurs 151a - 151 c sont connectés indirectement à des câbles 251a - 251 c de la pièce structurale 2, et la couche de référence 16 est connectée indirectement à une couche de référence 26 de ladite pièce structurale 2, par des moyens d'interconnexion 5, tels que des cavaliers en U, comme représenté sur la figure 4a.

La figure 4b représente un second mode de réalisation des moyens de connexion électrique 18, dans lequel lesdits moyens de connexion sont des connecteurs internes 182 qui sont intégrés entre des couches de la pièce structurale 1. Les connecteurs internes 182 sont accessibles via le bord de ladite pièce structurale, et sont géométriquement adaptés à des connecteurs internes 282 intégrés dans la pièce structurale 2, par exemple des connecteurs mâle/femelle, de sorte que lesdits connecteurs internes 182 et 282 assurent la continuité électrique lorsque les pièces structurales 1 et 2 sont assemblées bout à bout.

La figure 4c représente un troisième mode de réalisation des moyens de connexion électrique 18, dans lequel lesdits moyens de connexion sont un connecteur externe 181, monté en surface sur la face d'interconnexion de la pièce structurale 1, le long d'un côté de ladite pièce et de longueur semblable à la longueur dudit côté. Le connecteur externe 181 est par exemple un connecteur plat multibroches, chaque broche étant reliée à un câble conducteur 151a - 151c ou à la couche conductrice de référence 16. Le connecteur externe 181 est adapté géométriquement à un connecteur externe 281 sur la pièce structurale 2, tels que des prises mâle/femelle, pour assurer la continuité électrique lorsque les deux pièces structurales 1 et 2 sont assemblées bout à bout.

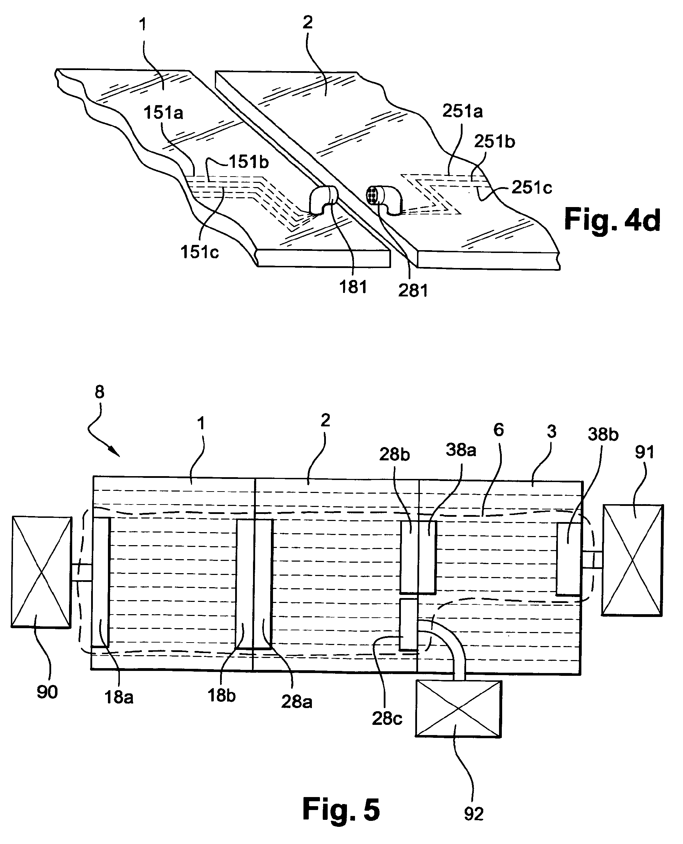

La figure 4d représente un mode voisin de réalisation dans lequel le connecteur externe 181 possède des dimensions inférieures à la longueur du côté de la pièce structurale 1, et des câbles conducteurs de la couche de réseau 15 se rejoignent en un point de convergence, par exemple pour une utilisation de connecteurs externes conventionnels.

Les moyens de connexion électrique 18 ne sont pas limités aux moyens décrits, et tous les connecteurs conventionnels utilisés pour la connexion électrique/électronique, externes ou internes, peuvent être utilisés.

Les câbles électriques 151a - 151c de la couche de réseau 15, qui ont tous un rôle structural dans la pièce structurale 1, ne sont pas nécessairement tous raccordés aux moyens de connexion 18, c'est-à-dire que lesdits câbles conducteurs n'ont pas nécessairement tous un rôle électrique de transmission de signaux électriques. Les moyens de connexion 18 sont par exemple agencés par rapport aux câbles conducteurs qui doivent être raccordés.

Dans un autre mode de réalisation, tous les câbles conducteurs 151a - 151 c sont raccordés aux moyens de connexion électrique 18, même s'ils ne sont pas tous utilisés pour la transmission de signaux électriques.

La figure 5 représente une structure travaillante assemblée 8 comportant une pluralité de pièces structurales 1, 2 et 3 rigides de forme sensiblement rectangulaire. Un réseau électrique 6 est formé à l'échelle de ladite structure travaillante en connectant les pièces structurales 1, 2 et 3 entre elles via des moyens de connexion électrique, respectivement 18a - 18b, 28a - 28c et 38a - 38b. La structure travaillante 8 est par exemple un plancher de véhicule de type aéronef, qui intègre le réseau électrique 6.

Le réseau électrique 6 relie des systèmes électriques/électroniques 90, 91 et 92, qui sont installés dans des zones différentes de l'aéronef.

Dans l'exemple illustré sur la figure 5, un premier système 90 est relié à un deuxième système 91 par les pièces structurales 1, 2 et 3. Le système 90 est également relié à un troisième système 92 par les pièces structurales 1 et 2.

Le système 90 est connecté électriquement à la pièce structurale 1 (c'est-à-dire aux câbles conducteurs 151a -151c de la couche de réseau 15 et à la couche conductrice de référence 16) par l'intermédiaire des moyens de connexion 18a. De manière similaire, les systèmes 91 et 92 sont connectés électriquement respectivement aux pièces 3 et 2 via des moyens de connexion respectivement 38b et 28c.

Les pièces structurales 2 et 3 sont interconnectées électriquement via des moyens de connexions électrique 28b et 38a.

Les différents câbles conducteurs des pièces structurales 1, 2 et 3 sont représentés par des traits discontinus et, dans l'exemple illustré sur la figure 5, certains des câbles conducteurs ont un rôle uniquement structural, d'autres ont un rôle à la fois structural et électrique et sont raccordés à des moyens de connexion.

Dans un mode préféré de réalisation, le réseau électrique 6 est redondant, c'est-à-dire qu'il comporte plusieurs liens pour transmettre un signal électrique d'un système électrique/électronique vers un autre, pour assurer la transmission dudit signal électrique en cas de défaillance d'un lien. La présente invention permet donc d'augmenter la résistance mécanique d'une pièce structurale en intégrant des câbles conducteurs orientés pour participer à ladite résistance mécanique. Les câbles conducteurs sont également utilisés pour transmettre des signaux électriques, et des pièces structurales selon la présente invention sont assemblées pour réaliser une structure travaillante à l'échelle de laquelle un réseau électrique est formé en connectant des câbles des différentes pièces via des moyens de connexion électrique.

## Revendications

1. Pièce structurale (1) rigide de structure travaillante d'aéronef en matériau composite stratifié, incorporant des câbles électriquement conducteurs, **caractérisée en ce que** ladite pièce structurale comporte :
- au moins trois couches structurales (11 - 13) comportant des fibres maintenues par une matrice réalisée à partir d'une résine thermodurcissable ou thermoplastique,
- au moins une couche conductrice de réseau (15) située entre deux desdites au moins trois couches structurales, ladite au moins une couche conductrice de réseau comportant un réseau de câbles électriquement conducteurs (151a - 151 c), lesdits câbles électriquement conducteurs étant agencés dans toute ladite pièce structurale de manière sensiblement régulière, et étant isolés électriquement desdites deux couches structurales par un matériau diélectrique (150),
- au moins une couche conductrice de référence (16) située entre deux desdites au moins trois couches structurales, ladite au moins une couche conductrice de référence étant électriquement conductrice dans toutes les directions,
- des moyens de connexion électrique (18) de raccordement électrique de pièces structurales entre elles, auxquels sont raccordés électriquement des câbles électriquement conducteurs (151a - 151 c) de l'au moins une couche de réseau (15) et l'au moins une couche conductrice de référence (16).

2. Pièce structurale (1) selon la revendication 1, comportant au moins quatre couches structurales (11 - 14) et au moins une couche d'un matériau de type alvéolaire (17), située entre deux desdites au moins quatre couches structurales.

3. Pièce structurale (1) selon la revendication 1 ou 2, dans laquelle l'au moins une couche conductrice de référence (16) est une feuille métallique ou un grillage composé de câbles métalliques ou métallisés.

4. Pièce structurale (1) selon la revendication 1 ou 2, dans laquelle l'au moins une couche de référence (16) est une couche d'un matériau alvéolaire métallique.

5. Pièce structurale (1) selon l'une des revendications précédentes, dans laquelle les moyens de connexion électrique (18) sont des trous métallisés (180a - 180d) débouchant sur une face d'interconnexion de ladite pièce structurale.

6. Pièce structurale (1) selon l'une des revendications précédentes 1 à 4, dans laquelle les moyens de connexion électrique (18) sont des connecteurs externes (181) montés en surface sur une face d'interconnexion de ladite pièce structurale.

7. Pièce structurale (1) selon l'une des revendications précédentes 1 à 4, dans laquelle les moyens de connexion électrique (18) sont des connecteurs internes (182) situés dans ladite pièce structurale et accessibles depuis une face d'interconnexion ou depuis un bord de ladite pièce structurale.

8. Pièce structurale (1) selon l'une des revendications précédentes, dans laquelle le matériau diélectrique (150) est de même composition que la résine thermodurcissable ou thermoplastique des couches structurales (11 - 14).

9. Pièce structurale (1) selon l'une des revendications précédentes, dans laquelle chaque couche structurale (11 - 14) comporte des fibres de carbone.

10. Structure travaillante (8) d'aéronef comportant au moins deux pièces structurales (1,2) rigides en matériau composite stratifié incorporant des câbles conducteurs électriquement, **caractérisée en ce que** :
- chaque pièce structurale (1,2) comporte :
o au moins trois couches structurales (11 - 13) comportant des fibres maintenues par une matrice réalisée à partir d'une résine thermodurcissable ou thermoplastique,
o au moins une couche conductrice de réseau (15) située entre deux desdites au moins trois couches structurales, ladite au moins une couche conductrice de réseau comportant un réseau de câbles électriquement conducteurs (151a - 151 c), lesdits câbles électriquement conducteurs étant agencés dans toute ladite pièce structurale de manière sensiblement régulière, et étant isolés électriquement desdites deux couches structurales par un matériau diélectrique (150),
o au moins une couche conductrice de référence (16) située entre deux desdites au moins trois couches structurales, ladite au moins une couche conductrice de référence étant électriquement conductrice dans toutes les directions,
o des moyens de connexion électrique (18) auxquels sont raccordés électriquement des câbles électriquement conducteurs (151a - 151 c) de l'au moins une couche de réseau (15) et l'au moins une couche conductrice de référence (16),
- les au moins deux pièces structurales (1,2) sont raccordées électriquement par lesdits moyens de connexion et forment un réseau électrique (6) intégré dans ladite structure travaillante assemblée.

11. Structure travaillante (8) selon la revendication 10, dans laquelle les moyens de connexions (18,28) des pièces structurales (1,2) sont raccordés électriquement par des moyens d'interconnexion (5).

## Patentansprüche

1. Starres Strukturteil (1) einer funktionalen Flugzeugstruktur aus einem Schichtverbundmaterial, das elektrisch leitende Kabel enthält, **dadurch gekennzeichnet, dass** das Strukturteil Folgendes umfasst:
- wenigstens drei Strukturschichten (11-13), die Fasern enthalten, die durch einen Grundstoff gehalten werden, der aus einem wärmehärtbaren oder wärmeformbaren Harz verwirklicht ist,
- wenigstens eine leitende Netzschicht (15), die sich zwischen zwei der wenigstens drei Strukturschichten befindet, wobei die wenigstens eine leitende Netzschicht ein Netz elektrisch leitender Kabel (151a-151c) enthält, wobei die elektrisch leitenden Kabel in dem gesamten Strukturteil im Wesentlichen regelmäßig angeordnet sind und von zwei Strukturschichten durch ein dielektrisches Material (150) elektrisch isoliert sind,
- wenigstens eine leitende Referenzschicht (16), die sich zwischen zwei der wenigstens drei Strukturschichten befindet, wobei die wenigstens eine leitende Referenzschicht in allen Richtungen elektrisch leitend ist,
- elektrische Anschlussmittel (18) für die elektrische Verbindung von Strukturteilen miteinander, mit denen elektrisch leitende Kabel (151a-151c) der wenigstens einen Netzschicht (15) und der wenigstens einen leitenden Referenzschicht (16) elektrisch verbunden sind.

2. Strukturteil (1) nach Anspruch 1, das wenigstens vier Strukturschichten (11-14) und wenigstens eine Schicht aus einem wabenartigen Material (17), die sich zwischen zwei der wenigstens vier Strukturschichten befindet, umfasst.

3. Strukturteil (1) nach Anspruch 1 oder 2, wobei die wenigstens eine leitende Referenzschicht (16) ein Metallblech oder ein Gitter, das aus metallischen oder metallisierten Kabeln gebildet ist, ist.

4. Strukturteil (1) nach Anspruch 1 oder 2, wobei die wenigstens eine Referenzschicht (16) eine Schicht aus einem metallischen Wabenmaterial ist.

5. Strukturteil (1) nach einem der vorhergehenden Ansprüche, wobei die elektrischen Anschlussmittel (18) metallisierte Löcher (180a-180d) sind, die in eine Zwischenverbindungsfläche des Strukturteils münden.

6. Strukturteil (1) nach einem der vorhergehenden Ansprüche 1 bis 4, wobei die elektrischen Anschlussmittel (18) externe Leiter (181) sind, die auf einer Zwischenverbindungsfläche des Strukturteils oberflächenmontiert sind.

7. Strukturteil (1) nach einem der vorhergehenden Ansprüche 1 bis 4, wobei die elektrischen Anschlussmittel (18) interne Verbinder (182) sind, die sich in dem Strukturteil befinden und von einer Zwischenverbindungsfläche oder von einem Rand des Strukturteils aus zugänglich sind.

8. Strukturteil (1) nach einem der vorhergehenden Ansprüche, wobei das dielektrische Material (150) die gleiche Zusammensetzung hat wie das wärmehärtbare oder wärmeformbare Harz der Strukturschichten (11-14).

9. Strukturteil (1) nach einem der vorhergehenden Ansprüche, wobei jede Strukturschicht (11-14) Kohlenstofffasern enthält.

10. Funktionale Flugzeugstruktur (8), die wenigstens zwei starre Strukturteile (1, 2) aus einem Schichtverbundmaterial, die elektrisch leitende Kabel enthalten, umfasst, **dadurch gekennzeichnet, dass**:
- jedes Strukturteil (1, 2) Folgendes umfasst:
∘ wenigstens drei Strukturschichten (11-13), die Fasern enthalten, die durch einen Grundstoff gehalten werden, der aus einem wärmehärtbaren oder wärmeformbaren Harz verwirklicht ist,
∘ wenigstens eine leitende Netzschicht (15), die sich zwischen zwei der wenigstens drei Strukturschichten befindet, wobei die wenigstens eine leitende Netzschicht ein Netz aus elektrisch leitenden Kabeln (151a-151c) enthält, wobei die elektrisch leitenden Kabel in dem gesamten Strukturteil im Wesentlichen regelmäßig angeordnet sind und von den zwei Strukturschichten durch ein dielektrisches Material (150) elektrisch isoliert sind,
∘ wenigstens eine leitende Referenzschicht (16), die sich zwischen zwei der wenigstens drei Strukturschichten befindet, wobei die wenigstens eine leitende Referenzschicht in allen Richtungen elektrisch leitend ist,
∘ elektrische Anschlussmittel (18), mit denen die elektrisch leitenden Kabel (151a-151c) der wenigstens einen Netzschicht (15) und der wenigstens einen leitenden Referenzschicht (16) elektrisch verbunden sind,
- wobei die wenigstens zwei Strukturteile (1, 2) durch die Anschlussmittel elektrisch verbunden sind und ein elektrisches Netz (6) bilden, das in die zusammengefügte bearbeitete Struktur integriert ist.

11. Bearbeitete Struktur (8) nach Anspruch 10, wobei die Anschlussmittel (18, 28) der Strukturteile (1, 2) durch Zwischenverbindungsmittel (5) elektrisch verbunden sind.

## Claims

1. Rigid structural part (1) of a load-bearing structure of an aircraft made of laminated composite material, incorporating electrically conducting cables, **characterized in that** said structural part comprises:
- at least three structural layers (11-13) comprising fibers held in place by a matrix made of a thermosetting or thermoplastic resin,
- at least one conducting network layer (15) located between two of said at least three structural layers, said at least one conducting network layer comprising a network of electrically conducting cables (151a - 151c), said electrically conducting cables being arranged throughout the structural part in a substantially regular manner and being electrically insulated from said two structural layers by a dielectric material (150),
- at least one conductive reference layer (16) located between two of said at least three structural layers, said at least one conductive reference layer being electrically conductive in all directions,
- electrical connection means (18) for electrically connecting structural parts to each other, to which electrically conducting cables (151a- 151 c) of the at least one network layer (15) and the at least one conductive reference layer (16) are electrically connected.

2. Structural part (1) according to claim 1, comprising at least four structural layers (11 - 14) and at least one layer of an alveolar-type material (17), located between two of said at least four structural layers.

3. Structural part (1) according to claim 1 or 2, in which the at least one conductive reference layer (16) is a metal sheet, or a grid comprised of metallic or metalized cables.

4. Structural part (1) according to claim 1 or 2, in which the at least one conductive reference layer (16) is a layer of a metallic alveolar material.

5. Structural part (1) according to one of the preceding claims, in which the electrical connection means (18) are metalized holes (180a - 180d) that open to an interconnection surface of said structural part.

6. Structural part (1) according to one of the preceding claims 1 to 4, in which the electrical connection means (18) are external connectors (181) surface-mounted on an interconnection surface of said structural part.

7. Structural part (1) according to one of the preceding claims 1 to 4, in which the electrical connection means (18) are internal connectors located in said structural part and accessible from an interconnection surface or from an edge of said structural part.

8. Structural part (1) according to one of the preceding claims, in which the dielectric material (150) is of the same composition as the thermosetting or thermoplastic resin of the structural layers (11 - 14).

9. Structural part (1) according to one of the preceding claims, in which each structural layer (11 - 14) comprises carbon fibers.

10. Load-bearing structure (8) of an aircraft comprising at least two rigid structural parts (1, 2) made of laminated composite material incorporating electrically conducting cables, **characterized in that**:
- each structural part (1, 2) comprises:
o at least three structural layers (11-13) comprising fibers held in place by a matrix made of a thermosetting or thermoplastic resin,
o at least one conducting network layer (15) located between two of said at least three structural layers, said at least one conducting network layer comprising a network of electrically conducting cables (151a - 151 c), said electrically conducting cables being arranged throughout the structural part in a substantially regular manner and being electrically insulated from said two structural layers by a dielectric material (150),
o at least one conductive reference layer (16) located between two of said at least three structural layers, said at least one conductive reference layer being electrically conductive in all directions,
o electrical connection means (18), to which electrically conducting cables (151a - 151 c) from the at least one network layer (15) and the at least one conductive reference layer (16) are electrically connected,
- the at least two structural parts (1, 2) are electrically connected by said connection means and form an electrical network (6) integrated in said assembled load-bearing structure.

11. Load-bearing structure (8) according to claim 10, in which the connection means (18, 28) of the structural parts (1, 2) are electrically connected by interconnection means (5).
